# EUROPEAN PATENT APPLICATION

(11) **EP 4 822 984 A1**
(43) Date of publication of application: **14.10.2026**
(21) Application number: 26168034.2
(22) Date of filing: 26.03.2026
(51) Int. Cl.: H03B 5/12

(54) **A SWITCHABLE CAPACITOR CELL**

(30) Priority: 09.04.2025 IN 202541034692
(71) Applicant: NXP B.V., 5656 AG Eindhoven (NL)
(72) Inventor: Wadhwa, Sanjay Kumar, 5656AG Eindhoven (NL); Bruccoleri, Federico, 5656AG Eindhoven (NL); van Hartingsveldt, Koen, 5656AG Eindhoven (NL)
(74) Representative: Schwarzweller, Thomas

(57) **Abstract**

A capacitor cell includes two capacitor circuits and two cell nodes, where each capacitor circuit is located in a path between a circuit node of the cell and a respective cell node. The capacitor cell includes enabling transistors that are made conductive to enable the capacitance of the cell to be utilized by a circuit such as an oscillator for frequency control by an enable signal that has a voltage range between a low supply voltage and a high supply voltage. One of the enabling transistors is coupled between the cell nodes. Each of two enabling transistors includes a first current terminal coupled in a path to a respective cell node. The second current terminals of the two enabling transistors are biased at a bias voltage that is less than the high supply voltage when the enable signal is not asserted.

## Description

### BACKGROUND OF THE INVENTION

### Field of the Invention

This invention relates to a switchable capacitor cell.

### Background

Circuits such as oscillators, tuning circuits, filters, amplifiers, or integrators may use capacitance in performing their functions. For at least some of these circuits, the effective capacitance is adjustable to affect circuit operations. For example, some programmable oscillators utilize capacitor cells which can be selectively enabled or disabled to adjust the effective capacitance of the oscillator to adjust the oscillator frequency.

### Brief Description of the Drawings

The present invention may be better understood, and its numerous objects, features, and advantages made apparent to those skilled in the art by referencing the accompanying drawings.
Figure 1 is circuit diagram of a programmable oscillator according to some embodiments of the present invention.
Figure 2 is a circuit diagram of a capacitor cell according to some embodiments of the present invention.
Figure 3 is a circuit diagram of a capacitor cell according to some embodiments of the present invention.

The use of the same reference symbols in different drawings indicates identical items unless otherwise noted. The Figures are not necessarily drawn to scale.

### DETAILED DESCRIPTION

The following sets forth a detailed description of a mode for carrying out the invention. The description is intended to be illustrative of the invention and should not be taken to be limiting.

As disclosed herein, a capacitor cell includes two capacitor circuits and two cell nodes, where each capacitor circuit is located in a path between a circuit node of the cell and a respective cell node. The capacitor cell includes enabling transistors that are made conductive to enable the capacitance of the cell to be utilized by a circuit such as an oscillator for frequency control by an enable signal that has a voltage range between a low supply voltage and a high supply voltage. One of the enabling transistors is coupled between the cell nodes. Each of two enabling transistors includes a first current terminal coupled in a path to a respective cell node. The second current terminals of the two enabling transistors are biased at a bias voltage that is less than the high supply voltage when the enable signal is not asserted.

In some embodiments, biasing current terminals of enabling transistors at a bias voltage that is less than a high supply voltage when a capacitor cell is disabled, may allow for a decrease in the stress across the enabling transistors when the capacitive cell is disabled. Accordingly, enabling transistors with thin gate oxide may be implemented that are faster and provide the cell with a better enabled/disabled capacitance ratio than with thick gate oxide transistors.

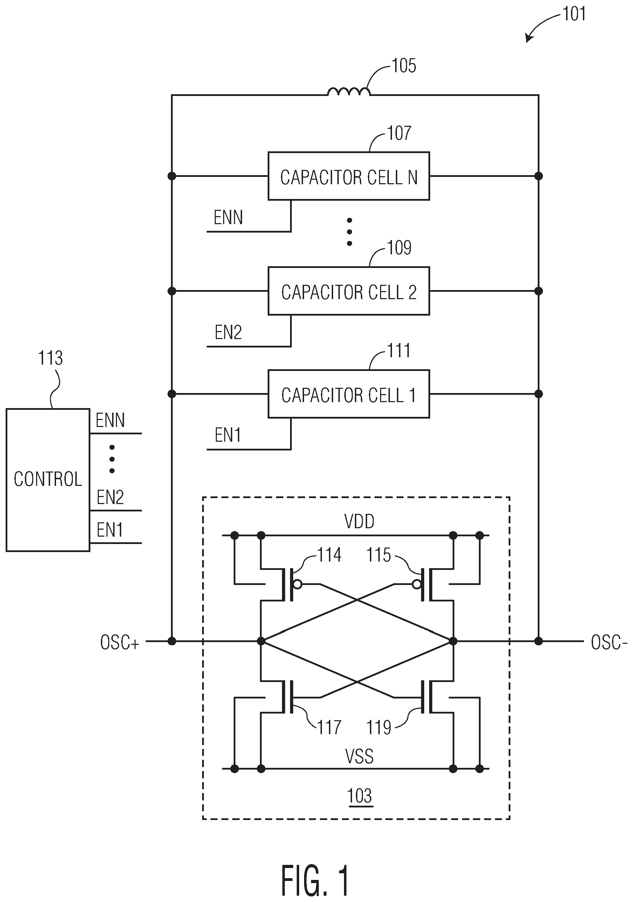

Figure 1 is a circuit diagram of a programmable oscillator 101 according to some embodiments of the present invention. Oscillator 101 includes two oscillator output nodes (OSC+ and OSC-) that provide complementary oscillating signals at a frequency that is determined by the inductance of inductor 105 and the effective capacitance provided by capacitor cells 107,109, and 111 and positive feedback circuit 103 of oscillator 101. Inductor 105 and capacitor cells 107, 109, and 111 form a tank circuit.

In the embodiment shown, positive feedback circuit 103 includes a pair of cross coupled NFETs 117 and 119 and a pair of cross coupled PFETS 114 and 115 that are connected to the oscillator output nodes (OSC+ and OSC-). The cross coupled configuration of circuit 103 causes the complementary oscillator signals to alternate between a high voltage signal state and a low voltage signal state at a frequency that is dependent upon the inductance of inductor 105, the programmable effective capacitance provided by capacitor cells 107, 109, and 111, and positive feedback circuit 103.

Oscillator 101 includes a controller 113 that provides enable signals (EN1 -ENN) to the capacitor cells 107, 109, and 111 to selectively enable the capacitor cells to adjust the capacitance provided by cells 107, 109, and 111 for changing the frequency of the oscillating signals. Each of signals (EN1-ENN) can be placed in an asserted state to "enable" its respective capacitor cell (107, 109, 111) in the tank circuit. Each of signals (EN1-ENN) can be placed in a nonasserted state to disable its respective capacitive cell.

When in an enabled state, a capacitor cell provides its designed "enabled capacitance" to the tank circuit for setting the frequency of the oscillator signals. In some embodiments, each capacitor cell 107, 109, and 111 may be configured to provide a different amount of enabled capacitance to the tank circuit, depending upon the size and configuration of its capacitor circuits. Accordingly, different combinations of enable signals may be asserted to provide a desired effective capacitance for providing a desired frequency.

When in a disabled state, a capacitor cell may provide some capacitance to the effective capacitance of the tank circuit due to parasitic capacitance. However, it may be desirable for a cell to provide a lowest amount of "disabled capacitance" as possible in order to provide a maximum tuning range of the oscillator.

In other embodiments, an oscillator may have other configurations including having a different arrangement of capacitor cells and inductors and/or a different type of positive feedback circuit. For example, in some embodiments, a positive feedback circuit would not include PFETs 114 and 115 or it would not include the NFETs 117 and 119.

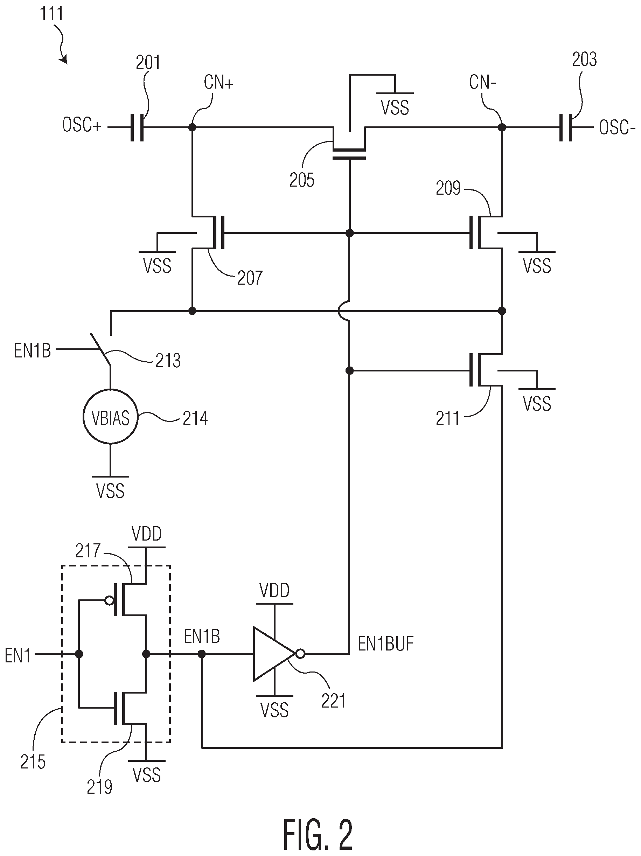

Figure 2 is a circuit diagram of capacitor cell 111 according to some embodiments of the present invention. Cell 111 includes two capacitors 201 and 203 for providing capacitance to the tank circuit of oscillator 101 when enabled. In one embodiment, capacitors 201 and 203 have a capacitance in the range of a few femto-farads but may be of another capacitance in other embodiments. Capacitor 201 includes one terminal connected to node OSC+ and another terminal connected to cell node CN+. Capacitor 203 includes one terminal connected to node OSC- and another terminal connected to cell node CN-. Capacitors 201 and 203 may be implemented by one or more fringe capacitors, MIMs capacitors, trench capacitors, MOS capacitors, other types of capacitors, or a combination of the capacitor types thereof.

An enabling NFET 205 includes a current terminal connected to node CN+ and another current terminal connected to CN-. Pull down enabling NFET 207 includes a drain connected to node CN+. The source of NFET 207 is connected to switch 213, connected to the source of enabling pull down NFET 209, and connected to the drain of NFET 211. NFET 209 includes a drain connected to node CN-. NFET 211 includes a source connected to the drains of PFET 217 and NFET 219 of inverter 215. The gates of NFETs 205, 207, 209, and 211 are connected to the output of inverter 221 to receive enable signal EN1BUF, which is logically the same as, and is controlled by the enable signal EN1 from controller 113 (see Figure 1). The enable signal EN1 is received at the gates of NFET 219 and PFET 217 of inverter 215. The output of inverter 215 produces the enable signal EN1B, which is inputted into inverter 221. The body bias terminals of NFETs 205, 207, 209, and 211 are connected to a VSS terminal, but may be connected to other voltages in other embodiments. Inverter 215 and NFET 211 are utilized as bias circuitry for biasing the sources of NFETS 207 and 209 at VSS when cell 111 is enabled.

Switch 213 is connected to receive at one terminal a voltage VBIAS from voltage source 214. Switch 213 is controlled by enable signal EN1B where switch 213 is closed when signal EN1B is at a high voltage (VDD). Switch 213 and voltage source 214 are utilized as bias circuitry to bias the sources of NFETs 207 and 209 at voltage VBIAS when cell 111 is disabled. Switch 213 may be implemented with an NFET, a PFET, another type of transistor, a passgate, or other type of switch. If switch 213 is implemented with a PFET (not shown), then the gate of the PFET would receive a signal inverse to EN1B. The source of PFET 217 and the high supply terminal of inverter 221 are connected to a VDD supply terminal. The source of NFET 219 and the low voltage supply terminal of inverter 221 are connected to the VSS terminal. In one embodiment, VDD is 0.8 volts and VSS is ground, but these voltages may be of other values in other embodiments, including VSS being at a negative voltage. VBIAS is less than VDD but greater than VSS.

During operation, to enable cell 111, controller 113 asserts the EN1 signal by placing it in a high voltage state (at VDD). In this state, EN1B is at VSS, and EN1BUF is at a high voltage, asserted state of VDD. With the enable signal EN1BUF being at an asserted state, NFETs 205, 207, 209, and 211 are placed in an intentional conductive state such that nodes CN+ and CN- are biased at VSS (through a path of conductive NFETs 207, 211, and 219, and through a conductive path of NFETs 209, 211, and 219, respectively) and are tied together via a conductive NFET 205. Accordingly, when enabled during operation, the capacitance seen between nodes OSC+ and OSC- is series combination of capacitance values of capacitor 201 and 203. This effective capacitance of cell 111 is added in parallel to the effective capacitance of oscillator 101.

In response to a change in the desired frequency in some instances, controller 113 disables cell 111 by placing the enable signal EN1 in a nonasserted voltage state of VSS which causes signal EN1B to go to a high voltage state of VDD and enable signal EN1BUF to go to a nonasserted voltage state of VSS to place NFETs 205, 207, 209, and 211 in an intentionally nonconductive state. Switch 213 is closed due to EN1B being at VDD (e.g., if switch 213 is implemented with an NFET). In such a condition, the sources of NFETs 207 and 209 are biased at VBIAS. The source of NFET 211 is biased at VDD through conductive PFET 217.

Because there is no direct bias of nodes CN+ and CN- in the disabled state, the voltage of nodes CN+ and CN- are affected by the leakage current through NFETs 207 and 209, respectively, and by the oscillating voltages of nodes OSC+ and OSC-, respectively. Even though NFETs 207 and 209 are in an intended nonconductive state, leakage current through NFETs 207 and 209 act to raise the voltage of nodes CN+ and CN- to VBIAS. Nodes OSC+ and OSC- reaching their positive peak voltages may raise the voltage of nodes CN+ and CN-, respectively, even higher during portions of the oscillation clock cycle. For example, when the voltage of node OSC+ moves towards its positive peak voltage, the voltage at node CN+ will also follow and go to a voltage higher than VBIAS, e.g., to a voltage of VBIAS plus the peak voltage of OSC+ (e.g., 0.4 V in some embodiments). Likewise, because oscillator 101 is symmetrical, when the voltage of node OSC- move towards its positive peak voltage, the voltage at node CN- will also follow and go higher.

The voltage of VBIAS is set at a lower voltage than VDD in order to limit the voltages of nodes CN+ and CN- from exceeding levels that could damage NFETs 205, 207, and 209 when cell 111 is disabled.

If the sources of NFETs 207 and 209 were biased at VDD, the voltages at nodes CN+ and CN-, respectively, would be higher (VDD plus the peak voltage of node OSC+ or node OSC-) when nodes OSC+ and OSC-, respectively, reach their positive peak voltages. During such peak times, nodes CN+ and CN- may exceed voltages where the reliability limit of the gate-to-drain voltages (VGD) of NFETs 207 and 209 and gate-to-drain voltage (VGD) and gate-to-source voltage (VGS) of NFET 205 may be exceeded if the sources of NFETs 207 and 209 are biased at VDD.

Accordingly, with embodiments described herein, the sources of the enabling pull down NFETs 207 and 209 are biased at a voltage lower than VDD when cell 111 is disabled so that during the positive peaks of nodes OSC+ and nodes OSC-, the voltages at nodes CN+ and CN-, respectively, do not cross the reliability limits of gate-to-drain voltages of NFETs 207 and 209 and the gate-to-drain voltage and gate-to-source voltage of NFET 205.

In some embodiments, the value of VBIAS must be high enough such NFETs 205, 207, and 209 do not enter an intentionally conductive state. For example, VBIAS - VSS must be higher than the voltage thresholds of NFETs 205, 207 and 209 (e.g., 0.35 Volts in some embodiments). Also, VBIAS must be high enough that NFET 205 does not become intentionally conductive when nodes OSC+ and OSC- reach their lowest voltages. In some embodiments, VBIAS is set at a voltage less than VDD but greater than or equal to ½ (VDD - VSS), which corresponds to VDD>VBIAS ≥ VDD/2 when VSS is equal to 0 Volts.

In some embodiments, the other cells 107 and 109 of oscillator 101 have a similar configuration as cell 111 in Figure 2. In some of these embodiments, the other cells may have different capacitance values for their capacitors that are similar to capacitors 201 and 203. However, the cells all may have the same capacitance values in other embodiments.

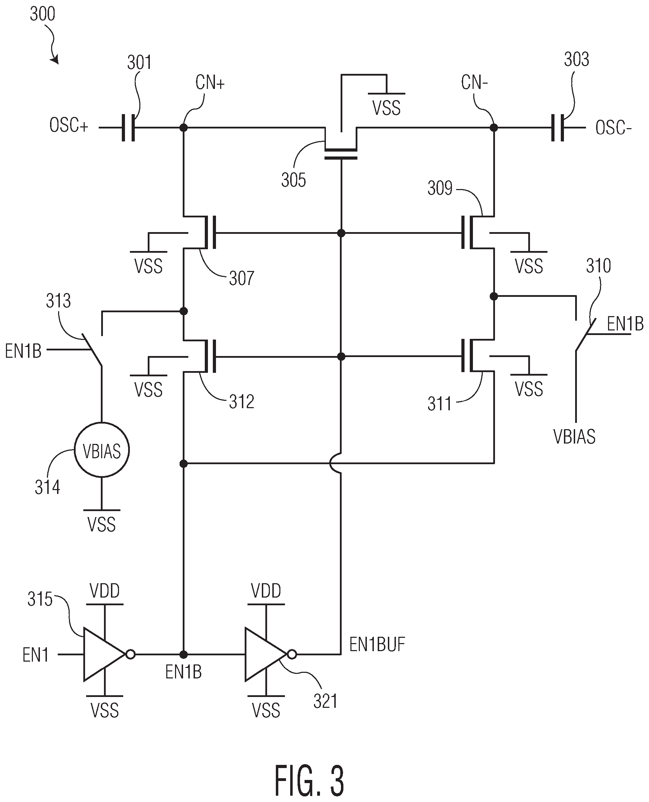

Figure 3 is a circuit diagram of a capacitor cell 300 according to some embodiments. Capacitor cell 300 is similar to cell 111 of Figure 2 where capacitors 301 and 303, NFETS 305, 307, and 309, and inverters 315 and 321 are similar to capacitors 202 and 203, NFETs 205, 207, and 209, and inverters 215 and 221, respectively. Cell 300 is different from cell 111 of Figure 2 in that its bias circuitry includes two NFETs 311 and 312 (instead of one NFET 211 in Figure 2), where NFET 312 is for biasing the source of NFET 307 and NFET 311 is for biasing the source of NFET 309 at VSS when cell 300 is enabled. The sources of NFETs 312 and 311 are connected to the output of inverter 315. The gates of NFETs 312 and 311 are connected to the output of inverter 321. NFETs 312 and 311 are made intentionally conductive when the EN1BUF enable signal goes to a high voltage state.

In addition, cell 300 includes two switches 313 and 310 connected to voltage source 314 for biasing the sources of NFETs 307 and 309, respectively, when the EN1B enable signal is at a high voltage value indicative that cell 300 is to be disabled. Switches 313 and 310 may be implemented with NFETs, PFETs, other types of transistors, passgates, or other types of switches.

In other embodiments, the oscillators and capacitor cells described herein may include other circuitry, have other configurations, and/or operate differently. For example, in Figure 2, the gates of NFETs 205, 207, 209, and 211 may be configured to receive the EN1 signal from controller 113 or receive a logically equivalent signal. As another example, a switchable capacitor cell may be implemented with PFET enablement transistors (not shown) including two enablement PFETs in a pull up configuration for biasing nodes CN+ and CN-at VDD when enabled and at a VBIAS voltage when disabled, where VBIAS is greater than VSS and less than VDD.

In addition to oscillators, switchable capacitor cells described herein (e.g., 111) may be used in other circuits such as in tuning circuits, filters, amplifiers, or integrators (none shown) to provide a variable effective capacitance. For example, in amplifiers, they may be utilized for frequency tuning, impedance tuning, or gain control. Such capacitor cells may be used in different types of systems such as e.g., computers, cell phones, automotive electronics, wearables, IOT systems, industrial, embedded systems, or communications systems. Switchable capacitor cells may be especially beneficial when used in programmable capacitor banks that are subject higher voltage signals.

As used herein, one item is "coupled" to another item either by being connected to the other item or by being coupled in a current path or in a signal path through at least one further item. For example, in Figure 2, the output of inverter 215 is coupled to the input of inverter 221 by being connected to it. The output of invertor 215 is coupled to the sources of NFETs 207 and 209 through NFET 211. A drain and a source are current terminals of a FET. As used herein, a "node" of a circuit is a conductive region between two or more circuit devices and designed to have an electric potential that is essentially the same (with at most only a negligible voltage drop) along the region. An "intentional conductive state" of a transistor is where the transistor is conductive in response to the voltage or current of the control terminal transistor being of a value that the transistor is intended to be conductive (e.g., such as when the gate-source voltage of an NFET exceeds its threshold voltage). Leakage current passing through a transistor does not mean that the transistor is in an intentional conductive state where the voltage or current of the control terminal is not at a value to place the transistor in a conductive state. Likewise, a transistor is in an intentional nonconductive state when the voltage or current of the control terminal transistor is of a value that the transistor is intended to be nonconductive.

As disclosed herein, providing a capacitor cell that includes pull down enabling transistors (or pull up transistors in some embodiments) that are biased at a voltage less than VDD when the cell is disabled may provide for a cell where the voltages of the enabling transistor do not exceed the safe operating area limits when the oscillator nodes are at a positive peak voltage. This may be especially important where interior nodes of the cell connected to the capacitors are not directly biased during disablement so as to provide a lower capacitance when disabled to improve the enabled/disabled capacitance ratio.

Features specifically shown or described with respect to one embodiment set forth herein may be implemented in other embodiments set forth herein.

In one embodiment, a circuit includes a capacitor cell. The capacitor cell includes a first capacitor circuit coupled between a first circuit node and a first cell node of the capacitor cell, a second capacitor circuit coupled between a second circuit node and a second cell node of the capacitor cell, a first transistor including a first current terminal coupled in a path to the first cell node, a second transistor including a first current terminal coupled in a path to the second cell node, and a third transistor including a first current terminal couple in a path to the first cell node and a second current terminal coupled in a path to the second cell node. The first transistor, the second transistor, and the third transistor, each includes a control terminal to receive an enable signal, wherein the first transistor, the second transistor, and the third transistor are placed in an intended conductive state in response to enable signal being placed in an asserted state to enable the capacitor cell in the circuit, wherein the first transistor, the second transistor, and the third transistor are placed in an intended nonconductive state by the enable signal being placed in a nonasserted state to disable the capacitor cell in the circuit. The circuit includes first bias circuitry coupled to a second current terminal of the first transistor and a second current terminal of the second transistor, the first bias circuitry configured to bias the second current terminal of the first transistor and the second current terminal of the second transistor at a bias voltage when the enable signal is in a nonasserted state. A signal range of the enable signal ranges between a low supply voltage of a low supply terminal and a high supply voltage of a high supply voltage terminal, wherein the bias voltage is at a voltage that is less than the high supply voltage but greater than the low supply voltage.

In a further embodiment, the capacitor cell further comprises second bias circuitry configured to bias the second current terminal of the first transistor and the second current terminal of the second transistor at one of the low supply voltage or the high supply voltage when the enable signal is in an asserted state.

In a further embodiment, the second bias circuitry includes a fourth transistor including a first current terminal coupled in a path to the second current terminal of the first transistor, the fourth transistor is in an intended conductive state when the enable signal is in an asserted state to bias the second current terminal of the first transistor at the one of the low supply voltage or the high supply voltage.

In a further embodiment, the enable signal is in an asserted state, a second current terminal of the fourth transistor is biased at the one of the low supply voltage or the high supply voltage, when the enable signal is in a nonasserted state, the second current terminal of the fourth transistor is biased at the other of the low supply voltage or the high supply voltage.

In a further embodiment, the second current terminal of the fourth transistor is coupled in a path to the low supply voltage terminal through a fifth transistor of an inverter of the capacitor cell for biasing the second current terminal of the fourth transistor at the low supply voltage when the fifth transistor is in an intended conductive state, and the second current terminal of the fourth transistor is coupled in a path to the high supply voltage terminal through a sixth transistor of the inverter for biasing the second current terminal at the high supply voltage when the sixth transistor is in an intended conductive state.

In a further embodiment, an output of the inverter is coupled to an input of a second inverter, wherein the enable signal is provided by the output of the second inverter.

In a further embodiment, the second bias circuity includes a fifth transistor including a first current terminal coupled in a path to the second current terminal of the second transistor, the fifth transistor is in an intended conductive state when the enable signal is in an asserted state to bias the second current terminal of the second transistor at the one of the low supply voltage or the high supply voltage.

In a further embodiment, the first current terminal of the fourth transistor is coupled in a path to the second current terminal of the second transistor.

In a further embodiment, the circuit comprising an oscillator. The first circuit node is characterized as a first output node that provides a first oscillator signal. The second circuit node is characterized as a second output node that provides a second oscillator signal. The second oscillator signal is complementary to the first oscillator signal. The oscillator further includes a positive feedback circuit including a first input coupled to the first output node and a second input coupled to the second output node, an inductor circuit coupled in a path between the first output node and the second output node, a plurality of capacitor cells including the capacitor cell, wherein each capacitor cell of the plurality of capacitor cells includes a configuration of three enabling transistors similar to the configuration of the first transistor, the second transistor, and the third transistor, where each capacitor cell includes a first capacitor circuit coupled in a path to the first output node and a second capacitor circuit coupled in a path the second output node; and a controller including a plurality of controller outputs where each controller output controls a respective enable signal of a respective capacitor cell of the plurality of capacitor cells to selectively enable the respective capacitor cell during an operation of the oscillator by placing the respective enable signal in an asserted state to place the three enabling transistors of the respective capacitor cell in an intended conductive state.

In a further embodiment during operation, the controller asserts selective capacitor cells of the plurality of capacitor cells to control an effective capacitance of the oscillator to control the frequency of the first oscillator signal and the second oscillator signal.

In a further embodiment, the bias voltage is greater than or equal to one half of the difference between the high supply voltage and the low supply voltage.

In a further embodiment, the first bias circuity includes a switch coupled in a path between a bias voltage source and the second current terminal of the first transistor, wherein the switch is closed when the enable signal is not asserted to bias the second current terminal of the first transistor at the bias voltage.

In a further embodiment, the switch is coupled in a path between the bias voltage source and the second current terminal of the second transistor, wherein the switch is closed when the enable signal is not asserted to bias the second current terminal of the second transistor at the bias voltage.

In a further embodiment, the capacitor cell includes a second switch coupled in a path between a reference bias source and the second current terminal of the second transistor, wherein the second switch is closed when the enable signal is not asserted to bias the second current terminal of the second transistor at the bias voltage.

In a further embodiment, when the enable signal is at the high supply voltage in the asserted state and at the low supply voltage in the nonasserted state.

In a further embodiment, the second current terminal of the second transistor is connected to the second current terminal of the first transistor.

In a further embodiment, the first transistor, the second transistor, and the third transistor are characterized as N-type transistors.

In another embodiment, a method for operating a circuit including a first circuit node and a second circuit node, wherein the circuit includes a capacitor cell including a first capacitor circuit, a second capacitor circuit, a first cell node, a second cell node, a first transistor, a second transistor, and a third transistor, the first capacitor circuit is located in a path between the first circuit node and the first cell node, the second capacitor circuit is located in a path between the second circuit node and the second cell node, the third transistor including a first current terminal coupled in a path to the first cell node and a second current terminal coupled in a path to the second cell node, the first transistor including a first current terminal coupled in a path to the first cell node, the second transistor including a first current terminal coupled in a path to the second cell node. The method includes operating the capacitor cell in an enabled state, wherein the operating the capacitor cell in the enabled state includes asserting an enable signal at a first voltage to place the first transistor, the second transistor, and the third transistor in an intended conductive state. The method includes operating the capacitor cell in a disabled state, wherein the operating the capacitor cell in the disabled state includes placing the enable signal in a nonasserted state at a second voltage to place the first transistor, the second transistor, and the third transistor in an intended nonconductive state and includes biasing the second current terminal of the first transistor and the second current terminal of the second transistor at a bias voltage, where the bias voltage is between the first voltage and the second voltage.

In a further embodiment, the operating the capacitor cell in the enabled state includes biasing the second current terminal of the first transistor and the second current terminal at the second transistor at the second voltage, wherein the second voltage is lower than the first voltage and lower than the bias voltage.

In a further embodiment, the circuit includes an oscillator, the method further includes generating a first oscillator signal at the first circuit node and a second oscillator signal at a second circuit node at a first frequency, wherein the generating at the first frequency includes operating the capacitor cell in the enabled state, and generating the first oscillator signal at the first circuit node and the second oscillator signal at the second oscillator node at a second frequency different than the first frequency, wherein the generating at the second frequency includes operating the capacitor cell in the disabled state.

## Claims

1. A circuit, comprising:
a capacitor cell comprising:
a first capacitor circuit coupled between a first circuit node and a first cell node of the capacitor cell;
a second capacitor circuit coupled between a second circuit node and a second cell node of the capacitor cell;
a first transistor including a first current terminal coupled in a path to the first cell node;
a second transistor including a first current terminal coupled in a path to the second cell node;
a third transistor including a first current terminal couple in a path to the first cell node and a second current terminal coupled in a path to the second cell node;
wherein the first transistor, the second transistor, and the third transistor, each includes a control terminal to receive an enable signal, wherein the first transistor, the second transistor, and the third transistor are placed in an intended conductive state in response to enable signal being placed in an asserted state to enable the capacitor cell in the circuit, wherein the first transistor, the second transistor, and the third transistor are placed in an intended nonconductive state by the enable signal being placed in a nonasserted state to disable the capacitor cell in the circuit;
first bias circuitry coupled to a second current terminal of the first transistor and a second current terminal of the second transistor, the first bias circuitry configured to bias the second current terminal of the first transistor and the second current terminal of the second transistor at a bias voltage when the enable signal is in a nonasserted state;
wherein a signal range of the enable signal ranges between a low supply voltage of a low supply terminal and a high supply voltage of a high supply voltage terminal, wherein the bias voltage is at a voltage that is less than the high supply voltage but greater than the low supply voltage.

2. The circuit of claim 1 wherein the capacitor cell further comprises second bias circuitry configured to bias the second current terminal of the first transistor and the second current terminal of the second transistor at one of the low supply voltage or the high supply voltage when the enable signal is in an asserted state.

3. The circuit of claim 2 wherein the second bias circuitry includes a fourth transistor including a first current terminal coupled in a path to the second current terminal of the first transistor, the fourth transistor is in an intended conductive state when the enable signal is in an asserted state to bias the second current terminal of the first transistor at the one of the low supply voltage or the high supply voltage.

4. The circuit of claim 3 when the enable signal is in an asserted state, a second current terminal of the fourth transistor is biased at the one of the low supply voltage or the high supply voltage, when the enable signal is in a nonasserted state, the second current terminal of the fourth transistor is biased at the other of the low supply voltage or the high supply voltage.

5. The circuit of claim 4 wherein:
the second current terminal of the fourth transistor is coupled in a path to the low supply voltage terminal through a fifth transistor of an inverter of the capacitor cell for biasing the second current terminal of the fourth transistor at the low supply voltage when the fifth transistor is in an intended conductive state;
the second current terminal of the fourth transistor is coupled in a path to the high supply voltage terminal through a sixth transistor of the inverter for biasing the second current terminal at the high supply voltage when the sixth transistor is in an intended conductive state.

6. The circuit of claim 5 wherein an output of the inverter is coupled to an input of a second inverter, wherein the enable signal is provided by the output of the second inverter.

7. The circuit of any of claims 3 to 6 wherein the second bias circuity includes a fifth transistor including a first current terminal coupled in a path to the second current terminal of the second transistor, the fifth transistor is in an intended conductive state when the enable signal is in an asserted state to bias the second current terminal of the second transistor at the one of the low supply voltage or the high supply voltage.

8. The circuit of any of claims 3 to 7 wherein the first current terminal of the fourth transistor is coupled in a path to the second current terminal of the second transistor.

9. The circuit of any preceding claim further comprising an oscillator, wherein:
the first circuit node is characterized as a first output node that provides a first oscillator signal;
the second circuit node is characterized as a second output node that provides a second oscillator signal, the second oscillator signal is complementary to the first oscillator signal;
the oscillator further comprising:
a positive feedback circuit including a first input coupled to the first output node and a second input coupled to the second output node;
an inductor circuit coupled in a path between the first output node and the second output node;
a plurality of capacitor cells including the capacitor cell, wherein each capacitor cell of the plurality of capacitor cells includes a configuration of three enabling transistors similar to the configuration of the first transistor, the second transistor, and the third transistor, where each capacitor cell includes a first capacitor circuit coupled in a path to the first output node and a second capacitor circuit coupled in a path the second output node;
a controller including a plurality of controller outputs where each controller output controls a respective enable signal of a respective capacitor cell of the plurality of capacitor cells to selectively enable the respective capacitor cell during an operation of the oscillator by placing the respective enable signal in an asserted state to place the three enabling transistors of the respective capacitor cell in an intended conductive state.

10. The circuit of claim 9 wherein during operation, the controller asserts selective capacitor cells of the plurality of capacitor cells to control an effective capacitance of the oscillator to control the frequency of the first oscillator signal and the second oscillator signal.

11. The circuit of any preceding claim wherein the bias voltage is greater than or equal to one half of the difference between the high supply voltage and the low supply voltage.

12. The circuit of any preceding claim, wherein the first bias circuity includes a switch coupled in a path between a bias voltage source and the second current terminal of the first transistor, wherein the switch is closed when the enable signal is not asserted to bias the second current terminal of the first transistor at the bias voltage.

13. The circuit of claim 12 wherein the switch is coupled in a path between the bias voltage source and the second current terminal of the second transistor, wherein the switch is closed when the enable signal is not asserted to bias the second current terminal of the second transistor at the bias voltage.

14. The circuit of claim 12 or 13 wherein the capacitor cell includes a second switch coupled in a path between a reference bias source and the second current terminal of the second transistor, wherein the second switch is closed when the enable signal is not asserted to bias the second current terminal of the second transistor at the bias voltage.

15. The circuit of any preceding claim wherein the enable signal is at the high supply voltage in the asserted state and at the low supply voltage in the nonasserted state.
